# EUROPÄISCHE PATENTSCHRIFT

(11) **EP 1 202 284 B1**
(45) Veröffentlichungstag und Bekanntmachung des Hinweises auf die Patenterteilung: **22.03.2006**
(21) Anmeldenummer: 01121863.3
(22) Anmeldetag: 11.09.2001
(51) Int. Cl.: G11C 11/16

(54) **Verfahren zur Verhinderung unerwünschter Programmierungen in einer MRAM-Anordnung**
Prevention method of unwanted programming in a MRAM memory device
Méthode de prévention de programmations indésirées dans un dispositif de mémoire MRAM

(30) Priorität: 31.10.2000 DE 10053965
(43) Veröffentlichungstag der Anmeldung: 02.05.2002
(73) Patentinhaber: Infineon Technologies AG, 81669 München (DE)
(72) Erfinder: Freitag, Martin, Dr., 81543 München (DE); Lammers, Stefan, Wappingerst Falls , NY 12533 (US); Gogl, Dietmar, Dr., 12524 Fishkill, NY (US); Roehr, Thomas, Dr., 85609 Aschheim (DE)
(74) Vertreter: Müller - Hoffmann & Partner

(56) Entgegenhaltungen:
- US-A- 6 097 626

## Beschreibung

Die vorliegende Erfindung betrifft ein Verfahren zur Verhinderung unerwünschter Programmierungen in einer MRAM-Anordnung (MRAM = magnetoresistiver Speicher), bei der Speicherzellen in einem Speicherzellenfeld in wenigstens einer Ebene an Kreuzungsstellen zwischen Wortleitungen bzw. Programmierleitungen und Bitleitungen liegen, wobei durch die zu einer selektierten Speicherzelle gehörenden Wortleitungen bzw. Programmierleitungen und Bitleitungen Programmierströme geschickt sind, die auch in wenigstens einer zu der selektierten Speicherzelle benachbarten Speicherzelle ein dort als Streumagnetfeld wirkendes Magnetfeld erzeugen.

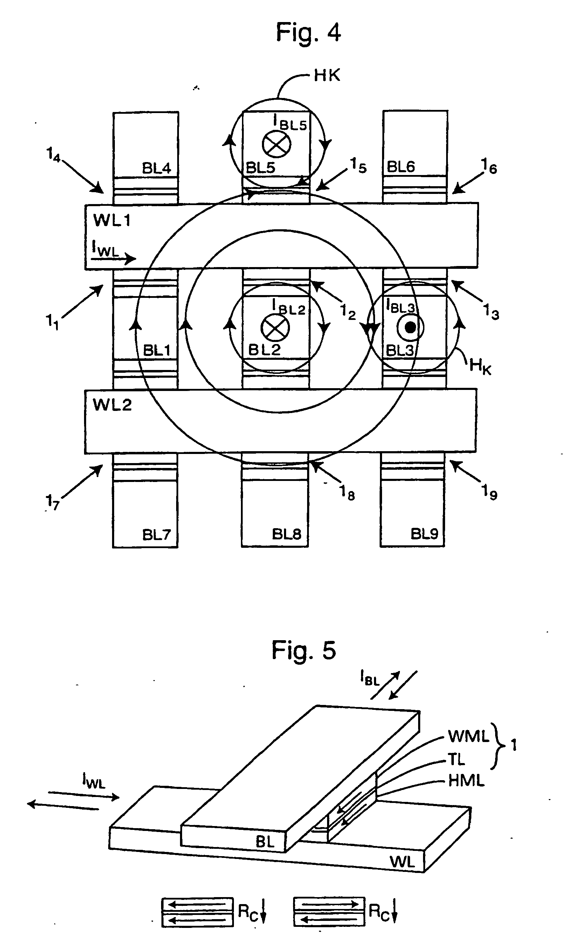

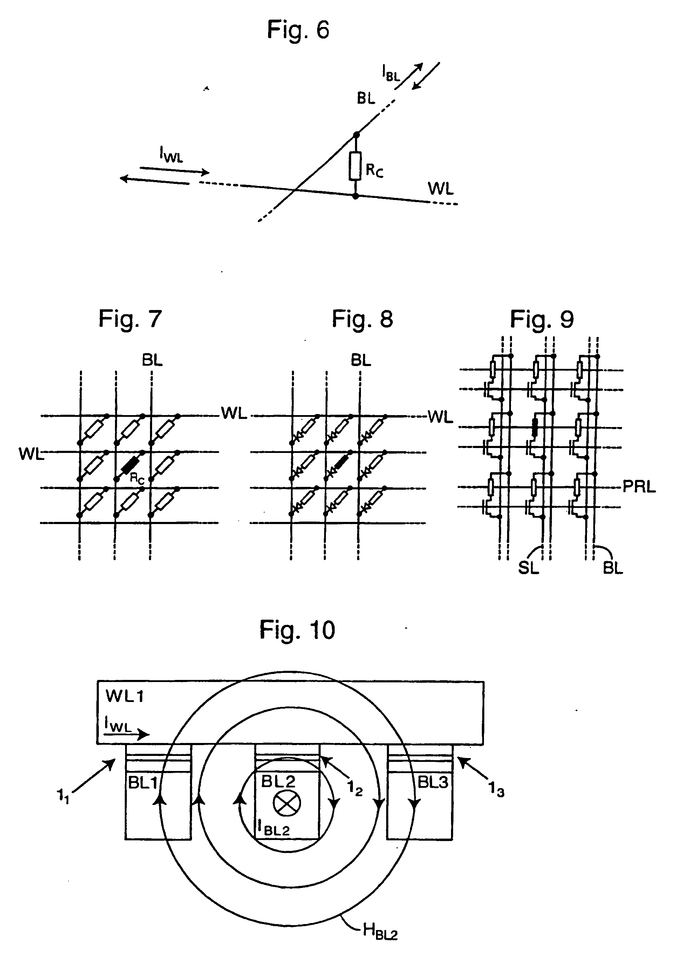

In Fig. 5 ist eine sogenannte MTJ-Speicherzelle (MTJ = Magnetic Tunnel Junction bzw. magnetischer Tunnelübergang) 1 zwischen einer Wortleitung WL und einer senkrecht zu dieser verlaufenden Bitleitung BL an deren Kreuzung gezeigt. Die MTJ-Speicherzelle besteht aus einem Mehrschichtsystem aus einer weichmagnetischen Schicht (freie Magnetschicht) WML, einer Tunnelbarrierenschicht TL und einer hartmagnetischen Schicht (feste Magnetschicht) HML. Eine Informationsspeicherung geschieht nun dadurch, dass die Magnetisierungsrichtung der weichmagnetischen Schicht WML in bezug auf der Magnetisierungsrichtung in der hartmagnetischen Schicht HML geändert bzw. gedreht wird. Die für diese Änderung der Magnetisierungsrichtung in der weichmagnetischen Schicht WML erforderlichen Magnetfelder werden durch einen Strom I_{WL} in der Wortleitung WL und einen Strom I_{BL} in der Bitleitung BL erzeugt. Diese Magnetfelder überlagern sich an der Kreuzung zwischen der Wortleitung WL mit der Bitleitung BL. Sind nämlich die Magnetisierungsrichtungen in den beiden magnetischen Schichten WML und HML gleich bzw. parallel zueinander, so besitzt die MTJ-Speicherzelle 1 einen niedrigen Widerstand R_{C}, während bei ungleichen bzw. antiparallelen Magnetisierungsrichtungen in den magnetischen Schichten WML und HML ein hoher Widerstand R_{C} vorliegt (vgl. das Ersatzschaltbild von Fig. 6). Diese Widerstandsänderung, die in Fig. 5 schematisch durch einen Pfeil ↑ bzw. ↓ hinter dem Symbol "R_{C}" veranschaulicht ist, wird zur Informationsspeicherung ausgenutzt. Für eine Drehung bzw. Änderung der Magnetisierungsrichtung in der weichmagnetischen Schicht WML ist es dabei ausreichend, wenn wenigstens einer der Ströme I_{WL} und I_{BL} in seiner Richtung umgeschaltet werden kann.

In Fig. 6 ist so die MTJ-Speicherzelle 1 als Widerstand R_{C} zwischen der Bitleitung BL und der senkrecht zu dieser verlaufenden Wortleitung WL schematisch veranschaulicht.

Aus den Fig. 5 und 6 wird sofort ersichtlich, dass in einer MRAM-Anordnung eine extrem hohe Speicherdichte erzielt werden kann, wenn mehrere Metallisierungssysteme mit jeweils zwischenliegenden MTJ-Speicherzellen übereinander gestapelt werden.

Für diese Stapelung sind nun drei verschiedene Array-Varianten möglich, welche schematisch in den Fig. 7 bis 9 gezeigt sind. Bei der in Fig. 7 dargestellten Variante liegen die einzelnen MTJ-Speicherzellen - veranschaulicht durch Widerstände - in einer Matrix direkt zwischen den Wortleitungen WL und den Bitleitungen BL. In einer solchen MRAM-Anordnung treten starke parasitäre Effekte auf, da bei einer selektierten Speicherzelle (vgl. Widerstand in Vollschwarz) Streuströme durch Speicherzellen, die mit der selektierten Wortleitung bzw. selektierten Bitleitung verbunden sind, nicht vermieden werden können.

Bei den Array-Varianten der Fig. 8 und 9 liegt jeweils eine Diode (Fig. 8) bzw. ein Transistor (Fig. 9) in Reihe zu den einzelnen MTJ-Speicherzellen. Diese Array-Varianten sind erheblich aufwendiger, was insbesondere für die Variante von Fig. 9 gilt, zumal dort zusätzlich zu den Bitleitungen BL noch Programmierleitungen PRL, Gateleitungen GL und Sourceleitungen SL vorgesehen werden müssen.

Unabhängig davon, welche der Array-Varianten der Fig. 7 bis 9 für den Aufbau eines Speicherzellenfeldes einer MRAM-Anordnung angewandt wird, muss bei einer Programmierung der Speicherzellen in die entsprechende Bitleitung BL und Wortleitung WL (bzw. Programmierleitung PRL in der Array-Variante von Fig. 9) der selektierten Speicherzelle jeweils ein Strom I_{BL} bzw. I_{WL} (in eine Wortleitung) eingeprägt werden, so dass das aus diesen Strömen resultierende Magnetfeld die selektierte MTJ-Speicherzelle an der Kreuzungsstelle beider Leitungen zu programmieren vermag. Dieser Vorgang ist schematisch in Fig. 10 veranschaulicht, welche Kreuzungsstellen einer Wortleitung WL1 mit Bitleitungen BL1, BL2 und BL3 veranschaulicht. Fließt hier ein Strom I_{WL} durch die Wortleitung BL1 und ein Strom I_{BL2} durch die Bitleitung BL2, so wird beispielsweise durch das von dem Strom I_{BL2} erzeugte Magnetfeld H_{BL2} nicht nur die MTJ-Speicherzelle 1₂ an der Kreuzungsstelle der Bitleitung BL2 mit der Wortleitung WL1 beeinflusst. Vielmehr wirkt dieses Magnetfeld H_{BL2} auch auf die MTJ-Speicherzellen 1₁ und 1₃ zwischen der Bitleitung BL1 bzw. BL3 und der Wortleitung WL1 ein, wie dies schematisch in Fig. 10 veranschaulicht ist.

Es kann also durchaus vorkommen, dass in einer MRAM-Anordnung auch neben der eigentlichen selektierten MTJ-Speicherzelle liegende MTJ-Speicherzellen durch Streufelder aufgrund der Ströme in der selektierten Wortleitung oder Bitleitung umprogrammiert werden, was als Programmierungsstörung bzw. Program Disturb bezeichnet wird. Dies gilt insbesondere für MRAM-Anordnungen, die die eingangs erwähnten Mehrschichtsysteme bilden, also speziell für die gerade allgemein gewünschten und angestrebten hochdichten Speicherarrays mit mehreren Pegeln von Leiterbahnen und dazwischenliegenden MTJ-Speicherzellen. Derartige Programmierungsstörungen bzw. "Program Disturbs" sind hier äußerst unerwünscht.

Im Einzelnen ist aus der US-A-6097626 ein Verfahren zur Verhinderung unerwünschter Programmierungen in einer MRAM-Anordnung bekannt, bei der Speicherzellen in einem Speicherzellenfeld einer Ebene an Kreuzungsstellen zwischen Wortleitungen und Bitleitungen liegen. Durch die zu einer selektierten Speicherzelle gehörenden Wortleitungen und Bitleitungen sind Programmierströme geschickt, die auch in einer zu der selektierten Speicherzelle benachbarten Speicherzelle ein dort als Streumagnetfeld wirkendes Magnetfeld erzeugen. Durch die Wortleitung der benachbarten Speicherzelle wird ein Kompensationsstrom geführt, der ein Kompensationsmagnetfeld liefert, das dem Streumagnetfeld entgegenwirkt.

Es ist Aufgabe der vorliegenden Erfindung, ein Verfahren zur Verhinderung unerwünschter Programmierungen in einer MRAM-Anordnung zu schaffen, mit dem Umprogrammierungen von zu einer selektierten Speicherzelle benachbarten Speicherzellen durch Streumagnetfelder besonders zuverlässig und auf einfache Weise verhindert werden kann.

Diese Aufgabe wird bei einem Verfahren der eingangs genannten Art erfindungsgemäß dadurch gelöst, dass durch die zur Bitleitung der selektierten Speicherzelle übernächste Bitleitung, die neben der benachbarten Speicherzelle verläuft, Ein Kompensationsstrom geführt wird, der ein Kompensationsmagnetfeld liefert, das dem Streumagnetfeld entgegenwirkt.

Bei dem beschriebenen Verfahren wird so die Beeinflussung von zu einer programmierenden Speicherzelle in MRAM-Anordnungen benachbarten Speicherzellen durch Streumagnetfelder mittels Kompensationsmagnetfelder vermieden. Diese Kompensationsmagnetfelder werden ihrerseits durch Kompensationsströme erzeugt, die in den entsprechenden Bitleitungen oder Wortleitungen bzw. Programmierleitungen von benachbarten Speicherzellen oder aber in gesonderten Leitungen fließen, die neben den gefährdeten Speicherzellen verlaufen. Damit können zuverlässig Programmierungsstörungen bzw. "Program Disturbs" in gefährdeten Speicher-zellen vermieden werden.

Besonders vorteilhaft ist das erfindungsgemäße Verfahren bei dessen Anwendung auf Mehrschichtsysteme, da bei diesen das Auftreten von Streumagnetfeldern infolge der großen Nähe der einzelnen Schichten zueinander problematisch ist.

Nachfolgend wird die Erfindung anhand der Zeichnungen näher erläutert. Es zeigen:
- Fig. 1: eine schematische Darstellung, die erläutert, wie Programmierungsstörungen einer MTJ-Speicherzelle durch ein Kompensationsmagnetfeld eliminiert werden,
- Fig. 2: eine schematische Darstellung, die erläutert, wie Programmierungsstörungen eines MTJ-Speicherelementes durch Kompensationsströme nach einem Ausführungsbeispiel der Erfindung eliminiert werden,
- Fig. 3: eine perspektivische Darstellung eines Mehrschichtsystems,
- Fig. 4: eine schematische Darstellung, die erläutert, wie Programmierungsstörungen in einem Mehrschichtsystem durch Kompensationsströme eliminiert werden,
- Fig. 5: eine übliche MTJ-Speicherzelle zwischen einer Bitleitung und einer Wortleitung in Perspektive,
- Fig. 6: ein Ersatzschaltbild der MTJ-Speicherzelle von Fig. 5 und
- Fig. 7 bis 9: verschiedene Array-Varianten für MRAM-Anordnungen.

Die Fig. 5 bis 9 sind bereits eingangs erläutert worden.

In den Figuren werden für einander entsprechende Bauteile jeweils die gleichen Bezugszeichen verwendet.

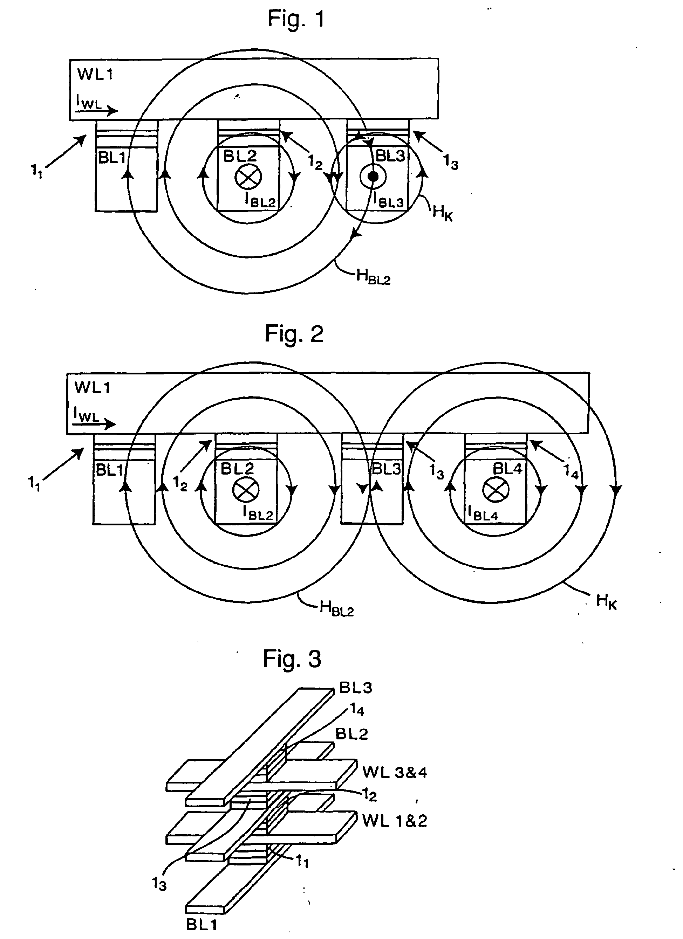

In den Fig. 1, 2 und 4 sind wie in der Fig. 10 aus Gründen einer vereinfachten Darstellung die Magnetfelder kreisförmig gezeichnet. Aufgrund der in der Regel rechteckförmigen Leiterquerschnitte für die Bitleitungen und Wortleitungen und der Überlagerung verschiedener Magnetfelder infolge der Ströme durch die Bitleitungen und Wortleitungen ergeben sich tatsächlich weitaus komplexere Magnetfeldverteilungen. Dies ändert aber nichts daran, dass bei diesen komplexeren Magnetfeldverteilungen grundsätzlich ähnliche Bedingungen vorliegen, wie sie anhand der kreisförmigen Magnetfelder erläutert werden sollen.

Bei der Anordnung von Fig. 1 wird davon ausgegangen, dass ähnlich wie bei der Anordnung von Fig. 10 die MTJ-Speicherzelle 1₂ an der Kreuzung der Bitleitung BL2 mit der Wortleitung WL1 programmiert werden soll. Dies geschieht nun durch Überlagerung der Magnetfelder, welche durch die Programmierströme I_{WL} in der Wortleitung WL1 und I_{BL2} in der Bitleitung BL2 erzeugt werden. Es ist in Fig. 1 wie in Fig. 10 nur das Magnetfeld H_{BL2} dargestellt, das durch den Programmierstrom I_{BL2} erzeugt wird, welcher in der Bitleitung BL2 in die Zeichenebene hineinfließt. Dieser Strom I_{BL2} erzeugt nun starke parallele Magnetfeldkomponenten im Schichtsystem der MTJ-Speicherzelle 1₂ an der Kreuzung der Bitleitung BL2 mit der Wortleitung WL1. Zusammen mit dem durch den Wortleitungsstrom I_{WL} gelieferten Magnetfeld wird dadurch die genannte MTJ-Speicherzelle 1₂ programmiert.

Der Strom I_{BL2}, der durch die Bitleitung BL2 fließt, erzeugt aber auch Streumagnetfelder im Bereich der Kreuzungen der Bitleitung BL1 sowie der Bitleitung BL3 mit der Wortleitung WL1. Durch diese Streumagnetfelder können die an diesen Kreuzungen liegenden MTJ-Speicherzellen 1₁ und 1₃ in unerwünschter Weise beeinflusst werden, so dass hier Programmierungsstörungen bzw. "Program Disturbs" auftreten. Diese Störungen liegen vor, obwohl die parallelen Magnetfeldkomponenten im Bereich dieser benachbarten MTJ-Speicherzellen 1₁ und 1₃ erheblich kleiner sind als die parallele Magnetfeldkomponente im Bereich der zu programmierenden MTJ-Speicherzelle 1₂.

Um nun solche Programmierungsstörungen im Bereich der benachbarten MTJ-Speicherzellen 1₁ und 1₃ zu verhindern, können Kompensationsmagnetfelder verwendet werden, indem beispielsweise durch die Bitleitung BL3 ein entsprechender Kompensationsstrom I_{BL3} geschickt wird, wie dies schematisch in Fig. 1 veranschaulicht ist. Durch das von diesem Kompensationsstrom I_{BL3} erzeugte Kompensationsmagnetfeld können die parallelen Magnetfeldkomponenten in der MTJ-Speicherzelle 1₃ nahezu aufgehoben werden. Gleiches gilt für die MTJ-Speicherzelle 1₁. Ein Kompensationsmagnetfeld kann gegebenenfalls auch durch eine neben der mit dem Strommagnetfeld beaufschlagten Bitleitung BL verlaufenden gesonderten Leitung L (vgl. Fig. 7) erzeugt werden.

Ein Ausführungsbeispiel des erfindungsgemäßen Verfahrens ist in Fig. 2 veranschaulicht. Bei dem Ausführungsbeispiel, bei dem wie bei der Anordnung von Fig. 1 ein in der Bitleitung BL2 fließender Programmierstrom I_{BL2} Streumagnetfelder im Bereich der MTJ-Speicherzellen 1₁ und 1₃ erzeugt, wird in eine zur Bitleitung BL2 übernächste Bitleitung BL4 und gegebenenfalls in weitere benachbarte Bitleitungen ein Strom eingeprägt, der das Streumagnetfeld aufgrund des Stromes I_{BL2} in der Bitleitung BL3 so weit reduziert, dass durch den Programmierstrom I_{BL2} in der Bitleitung BL2 keine Programmierstörung in der MTJ-Speicherzelle 1₃ zwischen der Bitleitung BL3 und der Wortleitung WL1 auftritt. Allerdings sollte der das Kompensationsmagnetfeld liefernde Strom I_{BL4} in der Bitleitung BL4 nicht so groß sein, dass die parallelen Streumagnetfeldkomponenten in der MTJ-Speicherzelle 1₃ völlig ausgelöscht werden, da sonst auch die MTJ-Speicherzelle 1₄ zwischen der Bitleitung BL4 und der Wortleitung WL1 programmiert werden würde. Es kann hier also "nur" eine Abschwächung des durch den Programmierstrom I_{BL2} erzeugten Streumagnetfeldes in der MTJ-Speicherzelle 1₃ erreicht werden, was aber für den praktischen Gebrauch vollkommen ausreichend ist.

Fig. 3 veranschaulicht, wie in einem Mehrschichtsystem Bitleitungen BL1, BL2 und BL3 mit Wortleitungen WL1 & 2 sowie WL3 & 4 zusammenwirken. MTJ-Speicherzellen 1₁, 1₂, 1₃ und 1₄ liegen also zwischen der Bitleitung BL1 und der Wortleitung WL1 & 2, der Wortleitung WL1 & 2 und der Bitleitung BL2, der Bitleitung BL2 und der Wortleitung WL3 & 4 sowie zwischen der Wortleitung WL3 & 4 und der Bitleitung BL3.

In Fig. 4 ist schematisch der Aufbau eines solchen Mehrschichtsystems veranschaulicht. Auch bei der anhand der Fig. 4 erläuterten Anordnung soll angenommen werden, dass die MTJ-Speicherzelle 1₂ zwischen der Wortleitung WL1 und der Bitleitung BL2 durch Programmierströme in der Wortleitung WL1 und in der Bitleitung BL2 programmiert werden soll. Programmierstörungen in der MTJ-Speicherzelle 1₃ können hier wie bei der Anordnung von Fig. 1 durch einen entsprechenden Kompensationsstrom I_{BL3} in der Bitleitung BL3 verhindert werden, um mit einem Kompensationsmagnetfeld eine parallele Streumagnetfeldkomponente im Bereich der MTJ-Speicherzelle 1₃ auszugleichen.

Kritischer sind aber die Verhältnisse in einer in einer anderen Ebene liegenden MTJ-Speicherzelle 1₅ zwischen der Wortleitung WL1 und der Bitleitung BL5: die MTJ-Speicherzelle 1₅ hat zwar einen ähnlichen Abstand von der Bitleitung BL2 wie die MTJ-Speicherzelle 1₃. In der MTJ-Speicherzelle 1₅ wirken aber infolge eines in der Bitleitung BL2 fließenden Programmierstromes I_{BL2} deutlich stärkere parallele Magnetfeldkomponenten als in der MTJ-Speicherzelle 1₃, so dass die Gefahr von Programmierstörungen in der MTJ-Speicherzelle 1₅ erheblich größer ist als in der MTJ-Speicherzelle 1₃. Diese Programmierstörungen können aber erfindungsgemäß in einfacher Weise verhindert werden, indem ein entsprechender Kompensationsstrom I_{BL5} durch die Bitleitung BL5 geschickt wird, wodurch ein Kompensationsmagnetfeld erzeugt wird, das das Streumagnetfeld aufgrund des Stromes I_{BL2} in der MTJ-Speicherzelle 1₅ aufhebt, wie dies schematisch in Fig. 4 angedeutet ist.

Aus der Anordnung von Fig. 4 ist deutlich zu ersehen, welche Bedeutung die Stromkompensation gemäß dem erfindungsgemäßen Verfahren in Mehrschichtsystemen besitzt. Dabei können selbstverständlich auch durch weitere Leitungen für Kompensationszwecke Kompensierströme geschickt werden.

Durch Leitungen, die zu einer selektierten Leitung benachbart sind, können Ströme geschickt werden, welche auch den Programmiervorgang in der selektierten Speicherzelle unterstützen, wenn dies beispielsweise Vorteile in Hinsicht einer besseren Selektivität mit sich bringt. Weiterhin ist es möglich, Kompensationsströme durch selbstjustierende Schaltungen anzupassen, um dadurch beispielsweise Auswirkungen von Prozessschwankungen bei der Herstellung der MRAM-Anordnung zu beseitigen.

### Bezugszeichenliste

- 1; 1₁, 1₂, 1₃, ...: MTJ-Speicherzellen
- BL; BL1, BL2, BL3, ...: Bitleitungen
- WL; WL1, WL2, ...: Wortleitungen
- R_{C}: Widerstand einer MTJ-Speicherzelle
- I_{BL}, I_{BL1}, I_{BL2}, ...: Bitleitungsstrom
- I_{WL}: Wortleitungsstrom
- H_{BL2}: Programmiermagnetfeld
- L: gesonderte Leitung
- H_{K}: Kompensationsmagnetfeld
- WML: weichmagnetische Schicht
- HML: hartmagnetische Schicht
- TL: Tunnelbarrierenschicht
- GL: Gateleitung
- PRL: Programmierleitung

## Patentansprüche

1. Verfahren zur Verhinderung unerwünschter Programmierungen in einer MRAM-Anordnung, bei der Speicherzellen (1; 1₁, 1₂, ...) in einem Speicherzellenfeld in wenigstens einer Ebene an Kreuzungsstellen zwischen Wortleitungen (WL) bzw. Programmierleitungen (PRL) und Bitleitungen (BL) liegen, wobei durch die zu einer selektierten Speicherzelle (1₂) gehörenden Wortleitungen (WL1) bzw. Programmierleitungen (PRL) und Bitleitungen (BL2) Programmierströme (I_{WL}; I_{BL2}) geschickt sind, die auch in wenigstens einer zu der selektierten Speicherzelle (1₂) benachbarten Speicherzelle (1₃) ein dort als Streumagnetfeld wirkendes Magnetfeld erzeugen,
**dadurch gekennzeichnet,**
**dass** durch die zur Bitleitung (BL2) der selektierten Speicherzelle (1₃; 1₅) übernächste Bitleitung (BL4), die neben der benachbarten Speicherzelle (1₃) verläuft, ein Kompensationsstrom geführt wird, der ein Kompensationsmagnetfeld liefert, das dem Streumagnetfeld entgegenwirkt.

2. Verfahren nach Anspruch 1,
**dadurch gekennzeichnet,**
**dass** der Kompensationsstrom schwächer als der Programmierstrom eingestellt wird.

3. Verfahren nach Anspruch 1 oder 2,
**dadurch gekennzeichnet,**
**dass** Kompensationsströme in einem Mehrschichtsystem in Bitleitungen in mehreren Ebenen eingeprägt werden.

4. Verfahren nach einem der Ansprüche 1 bis 3,
**dadurch gekennzeichnet,**
**dass** die Stärke der Kompensationsströme durch selbstjustierende Schaltungen gesteuert wird.

## Claims

1. Method for preventing unwanted programming in an MRAM arrangement, in which memory cells (1; 1₁, 1₂, ...) in a memory cell array are situated in at least one plane at crossing points between word lines (WL), or programming lines (PRL), and bit lines (BL), where programming currents (I_{WL}; I_{BL2}) are passed through the word lines (WL1), or programming lines (PRL), and bit lines (BL2) associated with a selected memory cell (1₂) and also produce a magnetic field in at least one memory cell (1₃) which is adjacent to the selected memory cell (1₂), said magnetic field acting as a stray magnetic field in the adjacent memory cell,
**characterized**
**in that** the bit line (BL4) which is next but one to the bit line (BL2) in the selected memory cell (1₃; 1₅) and runs next to the adjacent memory cell (1₃) carries a compensating current which yields a compensating magnetic field counteracting the stray magnetic field.

2. Method according to Claim 1,
**characterized**
**in that** the compensating current is set to be at a lower level than the programming current.

3. Method according to Claim 1 or 2,
**characterized**
**in that** compensating currents in a multilayer system are impressed in bit lines in a plurality of planes.

4. Method according to Claims 1 to 3,
**characterized**
**in that** the level of the compensating currents is controlled by self-aligning circuits.

## Revendications

1. Procédé de prévention de programmations non souhaitées dans un dispositif MRAM, dans lequel des cellules (1 ; 1₁, 1₂, ...) de mémoire se trouvent dans un champ de cellules de mémoire dans au moins un plan en des points d'intersection entre des lignes (WL) de mots ou des lignes (PRL) de programmation et des lignes (BL) de bits dans lequel on envoie, par les lignes (WL1) de mots ou les lignes (PRL) de programmation et les lignes (BL2) de bits appartenant à une cellule (1₂) de mémoire sélectionnée, des courants (I_{WL} ; I_{BL2}) de programmation, qui produisent aussi, dans au moins une cellule (I₃) de mémoire voisine de la cellule (I₂) de mémoire sélectionnée, un champ magnétique y agissant en tant que champ magnétique de fuite,
**caractérisé**
**en ce que** l'on fait passer dans la ligne (BL4) de bits, qui est par rapport à la ligne (BL2) de bits de la cellule (1₃ ; 1₅) de mémoire sélectionnée au-delà de la ligne suivante et qui s'étend à côté de la cellule (1₃) de mémoire voisine, un courant de compensation, qui donne un champ magnétique de compensation antagoniste du champ magnétique de fuite.

2. Procédé suivant la revendication 1,
**caractérisé**
**en ce que** l'on règle le courant de compensation de manière à ce qu'il soit moins intense que le courant de programmation.

3. Procédé suivant la revendication 1 ou 2,
**caractérisé**
**en ce que** l'on injecte des courants de compensation dans un système multicouche dans des lignes de bits dans plusieurs plans.

4. Procédé suivant l'une des revendications 1 à 3,
**caractérisé**
**en ce que** l'on règle l'intensité des courants de compensation par des circuits à auto-ajustement.
